# EUROPEAN PATENT SPECIFICATION

(11) **EP 4 622 404 B1**
(45) Date of publication and mention of the grant of the patent: **04.11.2026**
(21) Application number: 25194372.6
(22) Date of filing: 04.08.2022
(51) Int. Cl.: H05K 3/00, H05K 3/42, G06F 3/14, G09G 3/32, G09G 5/00

(54) **SYSTEMS AND METHODS FOR CONFIGURING A DISPLAY DEVICE AND DISPLAY SYSTEM**
SYSTEME UND VERFAHREN ZUR KONFIGURATION EINER ANZEIGEVORRICHTUNG UND ANZEIGESYSTEM
SYSTÈMES ET PROCÉDÉS DE CONFIGURATION D'UN DISPOSITIF D'AFFICHAGE ET SYSTÈME D'AFFICHAGE

(30) Priority: 05.08.2021 US 202163229642 P
(43) Date of publication of application: 24.09.2025
(60) Divisional application: 26206913.1
(62) Document number(s) of the earlier application(s) in accordance with Art. 76 EPC: 22765358.1 / 4 381 543
(73) Proprietor: Snap Inc., Santa Monica, CA 90405 (US)
(72) Inventor: KYLES, Ian, Santa Monica, 90405 (US); BEECH, Clive David, Santa Monica, 90405 (US)
(74) Representative: Mathys & Squire

(56) References cited:
- US-A1- 2002 163 513
- US-A1- 2005 078 104
- US-A1- 2015 301 781
- US-A1- 2018 323 180

## Description

### Technical Field

This disclosure relates to displays, for example, light-emitting diode (LED) displays, including LED displays and OLED displays, as well as microdisplays or micro versions of the same (e.g., microLED and microOLED displays). More particularly, the present disclosure is directed to configurable LED displays.

### Background

Typically, direct-view applications, with medium-sized displays for portable, wearable, mobile or handheld devices (i.e. not Micro Displays, and not monitors, TVs, etc.), are typically made with transmissive LCD or OLED technology with TFT backplanes. OLED displays suffer from short lifetime and limited brightness, while LCD displays require a backlight, which dissipates power for every pixel whether the pixel is on or off. TFTs, while inexpensive, have excess resistance (which wastes power) and are too large to make sophisticated circuitry under each pixel, and are thus limited to drive schemes in which each row of the display is driven in turn, with each pixel having a very short duty cycle, thus requiring high current densities in order to get adequate brightness. In contrast, while microLED displays have a long life, microLED array when coupled to the silicon-backplane to form a microLED display often may yield displays with random defects.

In constructing micro-LED displays with silicon backplanes for physically larger applications (i.e. not microdisplays, but direct-view displays such as those for **VR** headsets, wearables such as watches, and smartphones or even monitors and televisions), building a variety of shapes and sizes would normally require redesigning the display and manufacturing process for each new application. As the size of the display gets larger, yield continually reduces, making some applications cost-prohibitive or at least non-competitive.

US 2005/078104 A1 describes a tiled display device that is formed from display tiles having picture element (pixel) positions defined up to the edge of the tiles.

US 2018/323180 A1 describes a matrix-addressed tile that comprises a tile substrate having a two-dimensional array of pixels arranged in rows and columns defining a contiguous pixel area that includes all of the pixels.

US 2002/163513 A1 describes a display data packet that contains identification information and a display unit communication system that comprises a control unit, a terminal adaptor to which a terminal adaptor ID is assigned and which is connected to the control unit, and a display unit to which a display unit ID is assigned and which is connected to the terminal adaptor in series and drives a display element according to the display data packet supplied from the control unit.

US 2015/301781 A1 describes a device and method of providing a versatile illuminated panel for walls, product displays, and other surfaces.

### Summary

Displays, in accordance with embodiments of the present disclosure, may be utilized in applications including, but not limited to, projectors, head-up displays, and augmented reality (AR), mixed reality (MR), and virtual reality (VR) systems or devices, such as headsets or other near-eye devices or systems. Tiled or Tile-able displays and methods, in accordance with embodiments of the present disclosure, provide displays of varying sizes, and as such, a Tiled or Tile-able display is configured to accommodate the display size needed for various wearable and mobile devices that require or incorporate displays.

### Description of the Figures

Fig. 1 illustrates an array of Tiles for a circular watch display in accordance with embodiments of the present disclosure.
Fig. 2 illustrates Tiles with a seam in accordance with embodiments of the present disclosure.
Fig. 3 illustrates Operational Die (e.g., Backplane Die) conversion to a form capable of nearly- seamless abutment, in accordance with embodiments of the present disclosure.
Fig. 4 illustrates Cross-Section of Tile on PCB, in accordance with embodiments of the present disclosure.
Fig. 5 illustrates a backside of a Tile, in accordance with embodiments of the present disclosure.
Fig. 6 illustrates a Connection of Tiles to form an array in accordance with embodiments of the present disclosure.
Fig. 7 illustrates Tile Backplane Circuitry in accordance with embodiments of the present disclosure.
Fig. 8 illustrates Individual Pixel Circuitry, in accordance with embodiments of the present disclosure.
Fig. 9 illustrates a Serial Stream format, in accordance with embodiments of the present disclosure.

### Detailed Description

As required, detailed embodiments are disclosed herein. It must be understood that the disclosed embodiments are merely exemplary of various and alternative forms. As used herein, the word "exemplary" is used expansively to refer to embodiments that serve as illustrations, specimens, models, or patterns. The figures are not necessarily to scale and some features may be exaggerated or minimized to show details of particular components. In other instances, well-known components, systems, materials, or methods that are known to those having ordinary skill in the art have not been described in detail in order to avoid obscuring the present disclosure. Therefore, specific structural and functional details disclosed herein are not to be interpreted as limiting, but merely as a basis for the claims and as a representative basis for teaching one skilled in the art.

The disclosure uses a display composed of independently and individually-fabricated and independently-tested "Tiles" (solving the yield limitation, as they are smaller and are tested during manufacturing process, and may be repaired before the manufacturing process is complete, thereby increasing yield). Further, different wearable or mobile device manufacturers try to differentiate themselves with industrial designs that lead to widely-varying display sizes and shapes, which would necessitate new designs for each customer, but using a Tiled or Tile-able display and method, in accordance with embodiments of the present disclosure, allows new displays to be designed or configured by arraying the Tiles on a PCB (which can be rapidly designed and fabricated as compared to creating a new silicon die and microLED array).

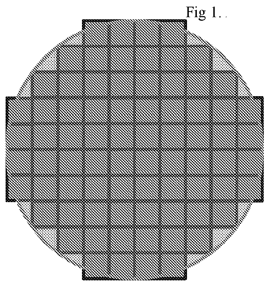

Figure 1 illustrates a pseudo-circular array of display Tiles. In an embodiment of the present disclosure an array of Tiles or display Tiles approximates a circle, and may be utilized to serve as a display device (e.g., an LED display device or LED panel) for a circular device. In an embodiment of the present disclosure, any number of Tiles can be arranged in any shape. In an embodiment of the present disclosure, an Illumination Device (e.g., a Tile) includes an Illumination Die (e.g., an LED Die) and an Operational Die (e.g., a Backplane Die).

In an embodiment of the present disclosure, an Illumination Die (e.g., an LED Die) includes Illuminating Elements coupled to or integrated into an Illumination Substrate (e.g., a Ga N substrate). In an embodiment of the present disclosure Illuminating Elements, for example, an array of Illuminating Elements (e.g., LEDs of any type or size) are formed in the Illumination Substrate. The Illuminating Elements (e.g., LEDs) or Illumination Array (e.g., an array of Illumination Elements) and the Illumination Substrate (e.g., an LED substrate) are integrated and/or coupled together, and form an Illumination Die. (e.g., an LED Die).

In an embodiment of the present disclosure, pixels are formed when the Illuminating Elements of the Illumination Die are coupled (e.g., electrically coupled) to circuitry (which includes at least pixel circuitry) that controls or is utilized to operate (e.g., including driving the respective Illumination Element or Illumination Elements). In an embodiment of the present disclosure, the pixel circuitry includes at least drive circuitry. In an embodiment of the present disclosure the drive circuitry includes at least Pixel Logic Circuitry that determines the on-/off state of the pixel as a function of time and Input/Output Circuitry that provides current to the LED. In an embodiment of the present disclosure, there is one set of pixel circuitry for each Illumination Element (e.g., LED).

In an embodiment of the present disclosure, each Illumination Die (e.g., LED Die) is coupled to (e.g., electrically coupled to) an Operational Die (e.g., Backplane Die). The Operational Die (e.g., Backplane Die) includes a Backplane Substrate, as well as pixel circuitry, and/or pixel-related circuitry.

In an embodiment of the present disclosure, the die is made from silicon and is referred to as a Silicon Operational Die (e.g., Backplane Die). In an embodiment of the present disclosure, the Operational Die (e.g., Backplane Die) includes circuitry (e.g., pixel circuitry) that is arranged on, coupled to, integrated into, formed in, deposited on, or embedded into the Backplane Substrate.

In an embodiment of the present disclosure the circuitry (e.g., pixel circuitry) or the drive circuitry is separated into at least the Pixel Logic Circuitry) and the Input/Output Circuitry. In an embodiment of the present disclosure the Pixel Logic Circuitry operates or is located in one or more sections of the Backplane Substrate that are different from one or more sections of the Backplane Substrate where the Input/Output Circuitry operates or is located.

In an embodiment of the present disclosure, the Pixel Logic Circuitry operates or is located in one or more strips or strip-like sections of the Backplane Substrate that are different from one or more strips or strip-like sections of the Backplane Substrate where the Input/Output Circuitry operates or is located.

In an embodiment of the present disclosure, each of the Illuminating Elements is associated with pixel circuitry (i.e., a drive circuit or drive circuitry that drives the illuminating element (e.g., determines the grey level output for an illuminating element). In an embodiment of the present disclosure, each of the Illuminating Elements is associated with its own pixel circuit (i.e., a drive circuit or drive circuitry that drives the illuminating element (e.g., determines the grey level output for an illuminating element). In an embodiment of the present disclosure, each of the Illuminating Elements is associated with Pixel Logic Circuitry or Circuit and Input/Output Circuitry or Circuit. In an embodiment of the present disclosure, the combination of each Illuminating Element (e.g., an LED) and its respective circuitry (e.g., pixel circuitry) that includes, but is not limited to, drive circuitry, form a pixel of the Tile. In an embodiment of the present disclosure, there is an electrical contact element between the LED and the pixel circuitry since they reside on different wafers before bonding. In an embodiment of the present disclosure, the electrical contact element may reside on the wafer where the LEDs are located or on the wafer where the pixel circuitry is located.

In an embodiment of the present disclosure, the combination of each Illuminating Element (e.g., an LED) and its respective circuitry, for example, each Illuminating Element (e.g., an LED) and its respective circuitry (for example, its respective Pixel Logic Circuitry and its respective Input/Output Circuitry), form a pixel of the Tile.

In an embodiment of the present disclosure, an Illumination Element is a Master Illumination Element. In an embodiment of the present disclosure, a Master Illumination Element includes more than one Illumination Element (e.g., LED). In an embodiment of the present disclosure, a Master Illumination Element includes at least three (3) Illumination Elements, for example, a set of three (3) Illumination Elements (e.g., LEDs).

In an embodiment of the present disclosure, a pixel is formed when an Illumination Element (e.g., an LED) is coupled to (e.g., electrically coupled to) circuitry (e.g., pixel circuitry) that drives each Illumination Element (e.g., LED). In an embodiment of the present disclosure, a Master Pixel is formed when a Master Illumination Element (e.g., collection or set of LEDs, for example three (3) LEDs) is coupled to (e.g., electrically coupled to) circuitry (e.g., pixel circuitry) that drives each Illumination Element (e.g., LED) of the Master Illumination Element. In an embodiment of the present disclosure, the Illumination Elements (e.g., LEDs) are collections of the 3 primary colors, and as the LEDs are grouped as collections, with Gaps in between, perceptually seamless abutment is achieved. In an embodiment of the present disclosure, a Tile includes more than one Master Pixel, for example, an array of Master Pixels. In an embodiment of the present disclosure, the pixel circuitry includes at least drive circuitry. In an embodiment of the present disclosure the drive circuitry includes at least Pixel Logic Circuitry and Input/Output Circuitry.

In an embodiment of the present disclosure, Tiles may be arranged, for example, in any pattern, for example, on a PCB. In an embodiment of the present disclosure, Tiles may be arranged, for example, in any pattern, for example, on a PCB to form a display. For purposes of illustrating use of Tiles, in accordance with embodiments of the present disclosure, a pseudo-circular array of tiles is illustrated in FIG. 1. For example, as shown in FIG. 1, a pseudo-circular array of display Tiles is arranged on a printed circuit board (PCB) (not shown) and is utilized for a watch face display. In the example shown, 88 Tiles, in accordance with embodiments of the present disclosure, of 3.6mm x 3.6mm each, containing 60x60 pixels per Tile are arrayed to form, for example, a 36mm-diameter watch face. However, it would be understood by one of ordinary skill in the art that the number of Tiles, number of pixels and/or Master Pixels per Tile, the shape of a Tile, and/or the shape of an array of Tiles may vary. In an embodiment of the present disclosure, the pattern or arrangement of Tiles on a PCB may vary.

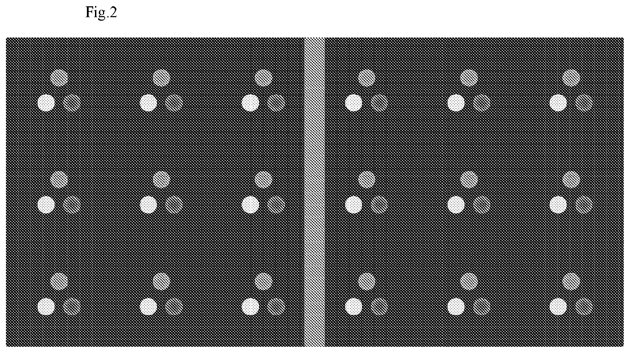

In an embodiment of the present disclosure, as illustrated in FIG. 2, adjacent Tiles are arranged on a PCB with a space, gap, or seam in between them. As illustrated in FIG. 2, in an embodiment of the present disclosure, there is a space, gap, or seam between sides or edges of two adjacent Tiles (where each Tile has one or more Master Pixels or collections of three (3) Illuminating Elements (e.g., LEDs and their associated pixel circuitry). It would be understood by one of ordinary skill in the art that any reference to LEDs includes any type of LED (e.g., LEDs, OLEDs, microLEDs or microOLEDs). As shown in FIG. 2, in an embodiment of the present disclosure, there is a gap, space, or seam between the adjacent Tiles. It would be understood by one of ordinary skill in the art that the number and colors of the LEDs in the Master Illumination Element or Master Pixels (e.g., sets of LEDs and/or circuitry electrically coupled to each of the LEDs) may vary.

In an embodiment of the present disclosure, a pitch (i.e., a center-center distance between Illumination Elements (e.g., Master Pixels, Master Illumination Elements, or collections of Illumination Elements (e.g., LEDs)) must be such that the space between the Illumination Elements (e.g., Master Pixels, Master Illumination Elements, pixels, or collections of Illumination Elements (e.g., LEDs)) is sufficient to allow for a gap, seam, space without interrupting the pixel pitch (i.e., the distance between a center of one Illumination Element (e.g., Master Pixel or Master Illumination Element)) and the center of another Illumination Element (e.g., Master Pixel or Master Illumination Element)), and while maintaining that the pixel pitch is the same or substantially/approximately the same for all of the adjacent Illumination Elements (e.g., Master Illumination Elements or Master Pixels) or at least some of the adjacent Illumination Elements (e.g., Master Illumination Elements or Master Pixels). In an embodiment of the present disclosure, when a Tile is a monochromatic Tile, the master pixel and the pixel are the same.

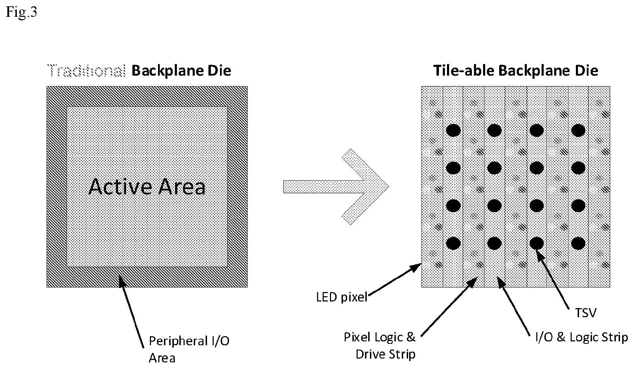

Figure 3 illustrates the differences between a traditional Backplane Die and a Tiled or Tile-able Operational Die (e.g., Backplane Die), for example, an Operational Die (e.g., Backplane Die (such as a Silicon Backplane Die)), in accordance with embodiments of the present disclosure, that has a form with apparently seamless abutment of Tiles, as the pitch between Master Illumination Elements or Master Pixels is the same. The traditional die floorplan has or includes 1/0 and logic circuitry regions (whereby the input regions include 1/0 buffers and the buffers are utilized to translate between externally used logic levels and internal logic levels, and the logic regions include registers, state machines and pixel drive circuitry, and are utilized to receive image data from the outside, distribute it to pixels in the active area).

In the traditional die plan, the input and logic regions are located or positioned around an active area of the display (i.e., a region containing pixels that will generate, for example, an image). In an embodiment of an Operational Die, in accordance with embodiments of the present disclosure, the Operational Die (e.g., a Tile-able Backplane, Backplane Die such as a Silicon Backplane Die) includes strips of alternating pixel logic circuitry and I/O circuitry. In an embodiment of the present disclosure, the I/O circuitry includes I/O buffers, and the buffers are utilized to translate between externally used logic levels and internal logic levels. In an embodiment of the present disclosure, the logic regions include registers, state machines and pixel drive circuitry, and are utilized to receive image data from the outside, distribute it to pixels in an active area), and the wiring is arranged in rows and columns, such that the connections to the LED pixels are maintained in an array. In an embodiment of the present disclosure, Illumination Elements, for example, LEDs, may be positioned above the pixel logic circuitry or strips, the I/O circuitry or strips, or above both the pixel logic circuitry or strips and the I/O circuitry or strips. In an embodiment of the present disclosure, the circuitry strips are embedded in the Backplane Substrate of the Operational Die.

The traditional backplane typically contains peripheral bond pads on a silicon die or bump/pillar connections on a silicon die to connect I/O buffers to a circuit board or package. The Tiled or Tile-able Backplane differs from the Traditional backplane, as the Tiled or Tile-able Backplane, in accordance with embodiments of the present disclosure, has Through-Silicon Vias (TSVs) that are utilized to connect or electrically couple one side or a front side of a Operational Die (e.g., a Backplane Die such as a Silicon Backplane Die) on which the Illumination Die (including, for example, the Illumination Elements ( e.g., LEDs) or Master Illumination Elements or collections of LEDs that form Master Pixels when coupled or electrically coupled to pixel circuitry) to a second side or back side of the Operational Die (e.g., a Backplane Die such as a Silicon Backplane Die) and/or circuitry of a PCB.

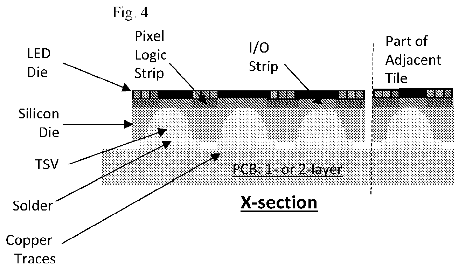

FIG. 4 illustrates a Cross-Section of a Tile on PCB. In an embodiment of the present disclosure, a Tile includes an Operational Die (e.g., a Backplane Die, such as a Silicon Backplane Die or wafer) coupled (e.g., bonded and/or electrically coupled) to an Illumination Die (e.g., an LED wafer or die) using bonding and connection methods that are well known in the art.

In an embodiment of an Illumination Die, in accordance with embodiments of the present disclosure, LEDs are formed in, integrated into, or fabricated in a substrate, for example, a Ga N substrate. However, it should be understood by one of ordinary skill in the art that the substrate material may vary, for example, the substrate may be any semiconductor material capable of forming light-emitting structures. In an embodiment of the present disclosure, metallic contacts are coupled to or integrated into the Illumination Die (e.g., LED Die) for electrically coupling the Illumination die to the Operational Die (e.g., Backplane Die, silicon die or Silicon Operational Die).

An Illumination Device (e.g., a Tile), in accordance with embodiments of the present disclosure, includes Vias (e.g., Through substrate vias or Through-silicon Vias (TSVs)) that are used to make connections between a first or back side and a second or front side of the Operational Die (e.g., silicon die) and the power supplies and interfaces, so as to provide power to the Tile circuitry (e.g., the I/O logic circuitry and/or strip, the pixel circuitry logic circuitry and/or strip, and/or the conductive circuitry portions (e.g., copper deposits or other electrical conductive elements) deposited on, coupled to, or integrated into the PCB. In an embodiment of the present disclosure, the Vias (e.g., Through substrate vias or Through-silicon Vias (TSVs)) receive the data voltage inputs at the I/ O buffers, and are utilized to connect power and ground devices, components, and or sources to the Illumination Die (e.g., LED Die) and/or the Operational Die (e.g., Backplane Die).

In an embodiment of the present disclosure, the openings of the Through substrate vias, for example, Through-silicon Vias (TSVs), at or on the back of the Operational Die (e.g., silicon die) are wetted with solder or other conductive material for solder attachment to an underlying PCB or circuitry of an underlying PCB.

In an embodiment of the present disclosure, the Tile circuitry (e.g. I/O Logic circuit or circuitry strips and pixel or drive circuitry logic strips) is deposited, formed in, embedded, or integrated into the Operational Die (e.g., Backplane Substrate, Silicon Operational Die, or Backplane Die or silicon die). In an embodiment of the present disclosure, the Illumination Die (e.g., LED Die) is at least electrically connected, coupled and/or bonded to the Operational Die, and the silicon die is connected, coupled, electrically coupled or connected, and/or bonded to a PCB. In an embodiment of the present disclosure, there is connectivity between Tiles or between an array of Tiles via a PCB (i.e., a substrate that accommodates the Tiles or a substrate on which the Tiles are located, coupled, bonded, or positioned).

In an embodiment of the present disclosure, circuitry or one or more conductive elements are deposited onto, fabricated in, or integrated into the PCB (for example, on one or more sides of the PCB), and are utilized, for example: (1) to electrically connect the Illumination Die (e.g., LED Die) and/or Operational Die (e.g., Backplane Die) to power sources, or power, sources of data, sources of voltages, and/or sources of current and/or (2) to receive data, voltages, or other inputs. In an embodiment of the present disclosure, the circuitry or conductive elements or deposits on the PCB are made from a copper material and may be referred to as a copper traces or a copper trace. However, it would be understood by one of ordinary skill in the art that the conductive may be made from a conductive material other than copper. The PCB also serves as a structure that provides support, rigidity, or a rigid surface to an array of Tiles. In an embodiment of the present disclosure, the PCB may include one, two, or more layers of circuitry (e.g., any tile-related circuitry).

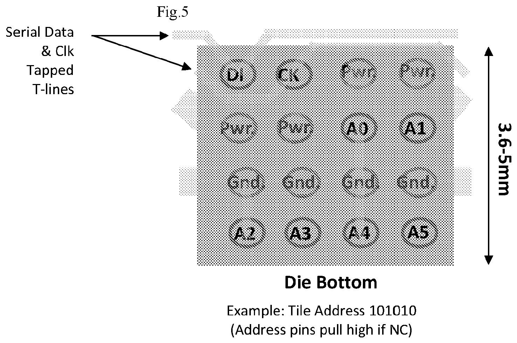

Figure 5 illustrates a backside of a Tile. In an embodiment of the present disclosure, as illustrated in FIG. 5, at the back or bottom of the Tile are an array of TSV openings, that are utilized to receive, for example, input data or voltages, output data or voltages, or signals. In an embodiment of the present disclosure, the TSV openings may be utilized to electrically connect the Illumination Die (e.g., LED Die) to circuitry of the PCB (e.g., circuitry (1) to electrically connect the LED Die to power sources, or power, sources of data, sources of voltages, and/or sources of current and/or (2) to receive data, voltages, or other inputs. In an embodiment of the present disclosure the TSVs may be utilized to output data from a Tile.

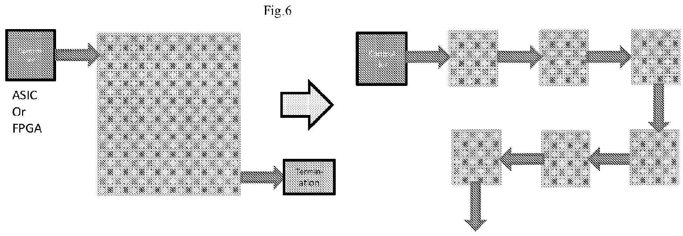

Shown in FIG. 5, are, for example, Vias in an Operational Die (e.g., Silicon Die) that are utilized to make power connections between the PCB (which may be connected to a voltage source or some other source of power) and the Illumination Die (e.g., LED Die). Figure 5 also illustrates an embodiment of the present disclosure, that has an example I-layer wiring pattern of the PCB, for example, wires or conductive elements deposited on the PCB or embedded in the PCB. In an embodiment of the present disclosure, the TSV labeled DI is utilized to connect serial Data input from a controller (which is illustrated in FIG. 6 and may be referred to as the Tile Array Controller, Array Controller, and/or Master Controller) to the Tiles. In an embodiment of the present disclosure, the controller, illustrated in FIG. 6 is external to a Tile and/or an array of Tiles. In an embodiment of the present disclosure, the controller (e.g., Tile Array Controller or Master Controller) is located or coupled to a substrate, such a PCB, to which the Tiles are also coupled or located. In an embodiment of the present disclosure, this controller controls the operation of a Tile, each Tile in an array of Tiles, and/or the operation of the array of Tiles as a unit. In an embodiment of the present disclosure, the controller (e.g., Tile Array Controller or Master Controller) distributes the data to the tiled and controls when they display new data. In an embodiment of the present disclosure, the arrows between the Controller of FIG. 6 and the arrows between the Tiles of FIG. 6, represent the Serial Data and Clock Tapped Transmission ("T") lines (i.e., conductive elements (e.g., wireline elements, for example, copper line wire elements) that are illustrated in FIG. 5, with respect to the PCB.

The TSV labeled CK is used to connect a clock voltage output from the controller to the Tiles to sample the serial data and provide a clock to the logic circuitry of the Tile. The Tile receives serial data (DI) and clock output (CK) from the controller, as will be described with respect to Fig. 6.

In an embodiment of the present disclosure, at least one Via is utilized to connect or deliver power to a Tile and/or Illumination Die (e.g., LED Die) via, for example, via a power rail (e.g., conductive elements, ground elements/components, wireline, and/or other components that are coupled to, deposited on, embedded in, and/or on integrated into the PCB) that is coupled or electrically connected to the Operational Die (e.g., Backplane Die or Silicon Operational Die). As a result, power is provided to the Illumination Device (e.g., a Tile and/or Illumination Die (e.g., LED Die), in accordance with embodiments of the present disclosure.

In an embodiment of the present disclosure, the Illumination Die (e.g., LED Die) is coupled to the Operational Die (e.g., Silicon Operational Die or Backplane Die). In an embodiment of the present disclosure, Through-Silicon Vias (e.g., four TSVs) are utilized to connect the PCB to the power rail (i.e., VDD) of the Illumination Die (e.g., LED Die) and/or Tile, and provides sufficient current-carrying capacity and low resistance. It would be understood by one of ordinary skill in the art that the number of Vias utilized to connect components of an Operational Die (e.g., Backplane Die) to a power source, other components of a display system, the PCB, and/or other components of the PCB (or electrically coupled to the PCB) may vary.

In an embodiment of the present disclosure, the controller (e.g., Tile Array Controller, Array Controller, Master Controller, and/or master controller chip), broadcasts or sends data to all of the Tiles or is utilized to broadcast or send data to all of the Tiles, or at least a portion of the Tiles, and each Tile (or at least some of the Tiles) knows which portion of the data to keep for itself based on its (i.e., the Tile's) address or, for example, based on how a Tile's address pins are tied. In an embodiment of the disclosure, the controller (e.g., Array controller) sends the data to a first Tile, and the data is then subsequently streamed or transmitted to a next Tile in array of Tiles. In an embodiment of the present disclosure, each Tile identifies and extracts data destined for it according to information in a header associated with the data sent from the controller (e.g., Array Controller, Master Controller, or master controller chip), as illustrated in FIG. 6, In an embodiment of the present disclosure, each Tile may receive data (for example, data represented as a voltage waveform or pulse) according to the address of the Tile identified in the address bits of the data received, from the controller (e.g., Array Controller, Master Controller, or master controller chip), at the array. For example, in an embodiment of the present disclosure, each of the TSVs, labeled A0-A5, identify a location within the LED or Master Pixel array, and is electrically connected to a pixel, Master Pixel, and/or LED in the array of LEDs, Master Illumination Elements or Master Pixels.

In an embodiment of the present disclosure, as illustrated in FIG. 6, Tiles are assembled into an array of Tiles and electrically interconnected (by, for example, by wireline) via, for example, a serial bus consisting of a data signal and optionally a clock signal. In an embodiment of the present disclosure, a controller (e.g., Array Controller, Master Controller, or master controller chip), as illustrated in FIG. 6, converts incoming image or video data of a format, for example, a standard format (e.g., MIPI DSI) into a custom serial format that the Tile can process.

The first or left side of FIG. 6 illustrates an array of Tiles, and a second or right side of the Tile (the side to which the arrow is pointing) illustrates that the array is composed of a multiple Tiles that are serially connected, and controlled by the controller (e.g., Array Controller, Master Controller, or master controller chip), that is coupled to at least one of the Tiles of the series of Tiles or multiple Tiles.

In an embodiment of the present disclosure, a custom format is determined in accordance with embodiments of being able to distribute data to all Tiles and having each Tile easily able to capture its own portion of the data. In an embodiment of the present disclosure, each Tile has a predetermined position in the array, as described with Fig. 5, and saves and/or displays data identified for it as a recognizes or knows its address, and knows how the data on the serial data input is arranged as it travels along the bus that is associated with its address or its geographical location or portion of the array (i.e., the whole array or at least a portion of the array). In an embodiment of the present disclosure, a Tile ignores any data on the serial bus that is not associated with its address.

In an embodiment of the present disclosure, a tapped transmission line, with a termination at the end, includes transmission line segments, and each transmission line segment (i.e., a transmission line segment between two Tiles in series) is tuned, by adjusting the width, in accordance with embodiments of transmission line matching methods (i.e., methods for providing a transmission path free of impairments such as reflections and for matching the impedance between the transmission line and the Tiles and or other components (e.g., electrical components) to which the transmission line is electrically connected, to give a controlled transmission line impedance when combined with the input capacitance of the data input or data input pin connections on each Tile).

In an embodiment of the present disclosure, while new data is arriving at a Tile from, for example, a source of image or video data, the previous image or video frame's data is being displayed, and allows for the new data or the next frame's data to be transmitted over the period of the entire video frame (i.e., the frame that is being displayed), which reduces the required data rate. For example, an array (e.g., an array of Master Pixels or Master Illumination Elements) in an embodiment of the present disclosure, as shown in Figure 1, provides, for example, 220,000 pixels, with 660,000 sub-Illuminating Elements (e.g., sub-pixels (e.g., red, green, blue LEDs)) each needing 8 bits of data to define their brightness. In an embodiment of the present disclosure, the serial data rate required to support the embodiment illustrated in FIG. 1 is a 60Hz refresh rate at 158.4Mb/s.

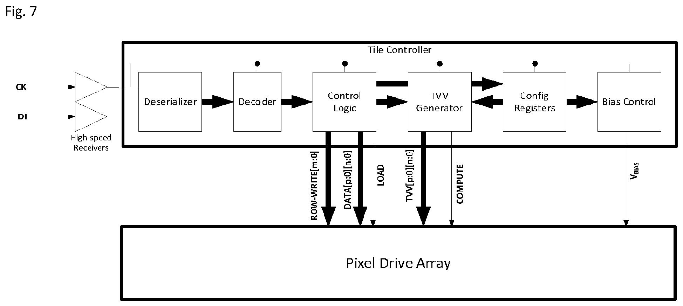

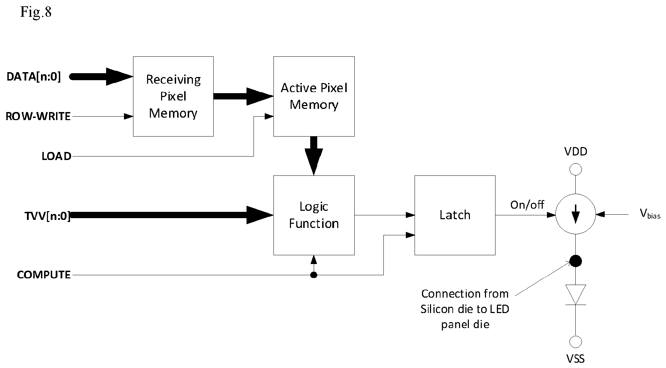

Figure 7 illustrates an embodiment of backplane circuitry, for example, Operational Die (e.g., silicon die or Tile Backplane) circuitry, in accordance with embodiments of the present disclosure. In an embodiment of the present disclosure, (1) an Operational Die (e.g., backplane or backplane die) circuitry of a Tile, includes or is coupled to receivers for the DIN (i.e., data inputs/signals) and CLK inputs/ signals (e.g., serial data and clock voltage inputs), logic circuitry, algorithms, and/or software algorithms or modules to decode serial data received at a receive logic circuit, circuitry, or block, and (2) the Operational Die (e.g., backplane or backplane die) circuitry of a Tile determines when such serial data is loaded into an array of pixel circuits, and when to update the pixels to display loaded data. In an embodiment of the present disclosure, the pixel circuits (as illustrated in FIG. 7) are included in the Operational Die (e.g., Backplane, Backplane Die or silicon die) circuitry, and the pixel circuits contain both receiving and active storage devices (e.g., memory devices). It would be understood by one of ordinary skill in the art that the pixel circuits may use any modulation method to drive the pixel circuits. A pixel structure, in accordance with embodiments of the present disclosure, will be further described in Fig. 8.

The Tile controller logic circuitry and/or device extracts data from the serial data stream (represented by, for example, a voltage waveform) transmitted over the serial bus that is destined for the Tile, and puts it on the DATA bus for the column of the pixel array to which it should be written, then uses the ROW-WRITE strobe to load it into the Master Pixel.

The Tile controller also produces a LOAD output control voltage to all Master Pixels or Master Illumination Element in the Tile (or at least a subset thereof) that controls the transfer data from the receiving memory to an active memory, and outputs a Time Varying Value on the TVV bus, which will be further described in Fig. 8.

The Tile control logic/circuitry/software/device also includes a Time-Varying-Value (TVV) generator which creates a changing digital pattern for use by the pixels. In an embodiment of the present disclosure, a bias control circuit, software, and/or device contains a brightness control register that provides a digital value to a DAC and a current DAC that converts the register value to a current. The current is then converted to a voltage suitable for biasing the current sources electrically coupled to the individual pixels or in the pixel circuitry electrically coupled to a pixel.

In an embodiment of the present disclosure, Configuration (Config) registers may be written to from data extracted from the incoming serial data received by the Deserializer, and may be used to control a bias current set by the Bias Control circuitry and/or device. In an embodiment of the present disclosure, the Config Registers may or may also store information about the Tiled display's X and Y pixel count (i.e., the pixel count in each row, and the pixel count in each column) and an activity state (such as sleep or wake) for the Tile.

As shown in FIG. 8, in an embodiment of the present disclosure, each sub-pixel (which is one of a set of, for example, 3, for each Master Pixel or Master Illumination Element, contains an illuminating element (e.g., an LED, microLED, OLED, or microLED device or component) that is electrically coupled to memory elements, for example, two sets of memory elements, logic function circuitry having an output that controls a latch to which it is electrically coupled (e.g., a final latch), a final latch and a current driver to supply modulated current to the LED. It would be understood by one of ordinary skill in the art that the number of memory elements, latches, and current drivers may vary.

In an embodiment of the present disclosure, a receiving storage device (e.g., a memory device or receiving pixel memory device) is loaded with image data or video data (for example, image or video grayscale data, from a Tile controller, which places or transmits data to be written to a Tile, which it has extracted from the serial data stream, by the Deserializer and decoder on the data bus of a column containing the pixel or Master Pixel to be written and then the Tile controller outputs a ROWWRITE signal for the row of the pixel to be written. It should be understood by one of ordinary skill in the art that other row-column scanning methods may be utilized to control the ROWWRITE operation.

Then, in an embodiment of the present disclosure, the Tile controller outputs a LOAD output voltage or signal that initiates transfer of data from the receiving storage device (e.g., a memory device or receiving storage memory device) to the active storage device (e.g., a memory or active pixel memory device). Then, in an embodiment of the present disclosure, the display cycle begins. During this cycle, the Tile controller provides a changing value or voltage on the Time-Varying Value (TVV) bus which pixel logic hardware and/or software or pixel logic hardware device or means and/or software function, algorithm, or module combines with the value (in the case of software) or value represented by a voltage in the active storage device, for example, memory to produce a time-varying voltage, for example, a single-bit voltage, voltage pulse or signal that is used to modulate the current. In an embodiment of the present disclosure, on each change of the TVV bus by the Tile controller, a COMPUTE signal or output generated by a counter in the Tile controller is asserted or output to logic function circuitry and/or a latch to induce the computation of the single-bit output or signal and latch it into the final latch, whose output directly controls the on/off state of the current source. The modulation by the pixel logic hardware and/or software may be any of a variety of resulting digital patterns, for example, **PWM** or binary-weighted pulse widths, serves to vary the brightness of each pixel according to the data that was loaded into the storage devices (e.g., memories).

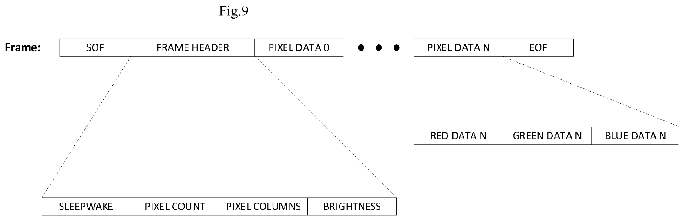

In an embodiment of the present disclosure, the serial data stream from the Tile Array Controller or Master Controller to the Tiles is formatted in frames corresponding in duration and frequency to a refresh rate of the display. In an embodiment of the present disclosure, as illustrated in FIG. 9, each frame contains a start-of-frame (SOF) marker, containing a unique pattern which the decode logic circuitry of the Tile controller can use to robustly detect the start of a frame (i.e., in data received by the Tile), followed by header information that describes the contents of the video data, such as a number of words and number of bits in each word to expect in the data stream, information about the number of pixels per row in the display as configured, and also containing global (i.e., for the entire pixel array or a predetermined portion thereof) register updates, such as brightness control or sleep/wake status.

In an embodiment of the present disclosure, a serial stream of data transmitted to the Tiles from the Tile controller or display controller may be encoded, for example, 8b10b or 8b9b encoding, in order to provide robust transmission and reception, detection of errors, and unique symbols for start of frame and other control purposes (for example, power-state control for a Tile). Each Tile saves its individual data, using its address to index into the received pixel data and identify the start and end of the data destined for that Tile.

In accordance with some embodiments of the present disclosure, a display device includes an Illumination Die, where the Illumination Die comprises at least one Illuminating Element at least one of coupled to, formed in and integrated into an illuminating element substrate; and a backplane device coupled to the Illumination Die, and where the backplane device comprises a Backplane Substrate and pixel circuitry, and the pixel circuitry is at least one of embedded in, integrated into, formed on, or coupled to the Backplane Substrate, and wherein said pixel circuitry comprises Pixel Logic Circuitry and input/output logic circuitry.

In some embodiments, the pixel circuitry comprises drive circuitry. In some embodiments, the at least one Illuminating Element comprises three Illuminating Elements. The Illuminating Elements are LEDs in some embodiments and are microLEDs in other embodiments. In some embodiments, the pixel circuitry is electrically coupled to the at least one illuminating element, and the pixel circuitry drives the at least one of the illuminating elements. In some embodiments, the pixel circuitry is coupled by conductive elements to the at least one Illuminating Element, and the pixel circuitry drives the at least one of the Illuminating Element.

In some embodiments, the backplane device is manufactured from a material comprising silicon or other semiconductor in which transistors may be formed. In some embodiments, the Illumination Element has a conductive portion, and the pixel circuitry contains conductive portions for electrically coupling the Illumination Element to its respective pixel circuit. The backplane device has TSVs in some embodiments, with a topside of the backplane device is connected to a backside of the backplane device by a conductive material or device on an end of the TSVs. In some embodiments, a PCB is electrically coupled to the backplane device via conductive elements that couple the PCB and the backplane device utilizing the TSVs. In some embodiments, the at least three Illumination Elements form a first Master Pixel. The display device comprises a second Master Pixel in some embodiments, wher the second Master Pixel is electrically coupled to the first Master Pixel via electrical conductive components or wireline. In some embodiments, the first Master Pixel and the second Master Pixel form a Tile.

In some embodiments, a display device comprises a plurality of Tiles, wherein a Tile comprises an Illumination Die. The Illumination Die comprises at least one illuminating element at least one of coupled to, formed in and integrated into an illuminating element substrate; and a backplane device coupled to the Illumination Die, wherein the backplane device comprises a Backplane Substrate and pixel circuitry, and wherein the pixel circuitry is at least one of embedded in, integrated into, formed on, deposited on, and coupled to the Backplane Substrate. The pixel circuitry comprises Pixel Logic Circuitry and input/output logic circuitry and a PCB. The plurality of tiles are electrically coupled via circuitry at least one of at least one of embedded in, integrated into, formed on, deposited onto and coupled to the Backplane Substrate and circuitry at least one of at least one of embedded in, integrated into, formed on, deposited onto and coupled to the PCB.

In some embodiments, the Pixel Logic Circuitry is at least one of arranged on, embedded in, integrated into, formed on, deposited onto or coupled to a first strip area of the Backplane Substrate. The input/output logic circuitry is at least one of arranged on, embedded in, integrated into, formed on, deposited onto or coupled to a second strip area of the backplane in some embodiments.

In some embodiments, a display system comprises a Tile controller, where the Tile controller controls operation of each Tile in an array or plurality of Tiles, and is included or integrated into an Operational Die of each of the Tiles, and where each Tile of the plurality of tiles has a Tile address. A Master controller is coupled to at least one of the Tiles in the plurality or array of Tiles, where the Master controller sends data to the Tile to which it is coupled, and wherein the Tile controller identifies Tile data in the data received from the Master controller, and wherein Tile data is a subset of the data sent from the Master controller, and wherein the Tile controller associated with the Tile address stores the Tile data at a memory component in, or associated with, the Tile.

In some embodiments, the data sent from the Master controller includes a Tile address in a header of the data sent from the Master controller. In some embodiments, the Master controller receives data from a first device of a first format, and wherein the Master controller converts the data to a second format suitable or that can be read or processed by the Tile or the Tile controller associated with the Tile.

In some embodiments, the first device is a device that generates and/or outputs images or image data. The Tiles of the plurality or array of Tiles are electrically connected in series in some embodiments. In some embodiments, image or video data is being sent to a Tile for display in a next frame while image or video data for a current frame is being displayed on the Tile. In some embodiments, each Tile comprises Illumination Elements, and each Illumination Element is coupled to a first storage device and a second storage device.

In some embodiments, the display system further comprises logic function circuitry electrically coupled to a latch, where the logic function circuitry performs a computation or Boolean logic function such as an equivalence or comparison function and generates an output that is received by a latch to which the logic function circuitry is coupled, and wherein the latch stores the output of the logic function circuitry, and wherein the latch is also electrically coupled to a current driver circuit or component, and wherein the current driver circuit or component is electrically coupled to an illuminating element , and wherein the current driver circuit or component supplies modulated current to the illuminating element, and wherein the current driver circuit or component may supply modulated current to the illuminating element in accordance with the output generated by the logic function circuitry.

In some embodiments, a display system comprises a Pixel Array of pixel elements, where each Illumination Element of a pixel or each Illumination Element of a Master Pixel of the pixel array is electrically coupled to pixel circuitry comprising a first storage device or receiving pixel memory device; a second storage device or active pixel memory device electrically coupled to the receiving pixel memory device. Logic function circuitry is coupled to the active pixel memory device. A latch is coupled to the logic function circuitry; and a current drive device coupled to the latch, and wherein the current drive device drives operation of each pixel or Master Pixel of the pixel array. A Tile controller comprises a Deserializer that receives incoming data from the receiving storage device. A Decoder is electrically coupled to the Deserializer, and the Deserializer extracts image or video data from a data stream, received at the Deserializer of the Tile controller, according to or when a Tile's address is in the data stream, and wherein the Deserializer controls writing of the extracted data to the first storage device or receiving pixel memory device.

In some embodiments, the Decoder decodes the extracted data after it has been extracted from the data stream, and wherein the Tile controller instructs a control logic block to write the extracted and subsequently decoded data to be placed on a data bus corresponding to or associated with a column that includes or contains Illuminating Elements, pixel, Master Pixel, LED, or collection of LEDs that has been identified as a destination for writing the extracted and subsequently decoded data. In some embodiments, the Tile controller outputs a ROW/WRITE output or signal to the row of the Illuminating Elements, pixel, Master Pixel, LED, or collection of LEDs that have been identified to receive the extracted and subsequently decoded data.

In some embodiments, the display system further comprises Control Logic circuitry of the Tile controller that outputs a LOAD output voltage or signal that initiates transfer of data from the receiving storage device to the second or active storage device. In some embodiments, the display system further comprises a TVV (Time-Varying Value) Generator, where after the data has been transferred to the second or active storage device, a display cycle begins, wherein during the display cycle, the TVV Generator provides a changing value or voltage on a Time-Varying Value (TVV) bus which pixel logic circuit or pixel logic device combines with the value or voltage in the second or active storage device, and produces a time-varying voltage that is used to modulate a current driver circuit or device electrically coupled to a Master Pixel or Master Illumination Element.

In some embodiments, on each change of the TVV bus by the TVV Generator, a COMPUTE signal or output generated by a counter in the TVV Generator of the Tile controller to logic function circuitry of the Pixel Array and/or a latch, and wherein the logic function circuitry computes or performs a Boolean logic function and generates a single-bit output or signal and outputs it to the latch, and wherein the output of the latch directly controls an on/off state of a current source and thereby an on/off state of the pixel, Master Pixel, LED, or collection of LEDs.

The above-described embodiments are merely exemplary illustrations of implementations that are set forth for a clear understanding of principles. Variations, modifications, and combinations may be made to the above-described embodiments without departing from the scope of the claims.

## Claims

1. A display system, comprising:
a plurality of tiles, wherein a tile comprises:
an illumination die comprising a plurality of illuminating elements at least one of coupled to, formed in and integrated into an illuminating element substrate; and
a backplane device coupled to the illumination die, the backplane device comprising:
a backplane substrate comprising a plurality of first strip areas and a plurality of second strip areas;
pixel logic circuitry at least one of arranged on, embedded in, integrated into, formed on, deposited onto or coupled to the plurality of first strip areas; and
input/output logic circuitry at least one of arranged on, embedded in, integrated into, formed on, deposited onto or coupled to the plurality of second strip areas, and
circuitry configured to electrically couple the plurality of tiles,
and **characterised in that**
the first strip areas and the second strip areas are provided in an alternating manner.

2. The display system of claim 1, wherein the illumination die is coupled to a front surface of the backplane substrate such that the plurality of first strip areas are aligned with the plurality of illuminating elements of the illumination die.

3. The display system of claim 2, wherein the plurality of tiles are arranged in an array on a printed circuit board, PCB, the PCB comprising the circuitry configured to electrically couple the plurality of tiles.

4. The display system of claim 3, wherein each respective tile is coupled to the PCB through a plurality of openings in a back surface of the respective backplane substrate, the plurality of openings in the back surface aligned with the plurality of second strip areas of the backplane device.

5. The display system of claim 3, wherein the PCB electrically couples the plurality of tiles in series.

6. The display system of any one of claims 1 to 5, wherein:
each tile of the plurality of tiles has a tile address and a tile controller; and
the display system further comprises a master controller coupled to at least one of the tiles in the plurality or array of tiles, wherein the master controller sends data to the tile to which it is coupled, the data having a header including a tile address, and wherein the tile controller identifies tile data in the data received from the master controller, and wherein tile data is a subset of the data sent from the master controller, and wherein the tile associated with the tile address stores the tile data at a memory component in, or associated with, the tile.

7. The display system of claim 6, wherein the master controller receives data from a first device of a first format, and wherein the master controller converts the data to a second format suitable for, or that can be read or processed by, the tile.

8. The display system of claim 7, wherein the first device is a device that generates and/or outputs image or video data.

9. The display system of claim 6, wherein the tiles of the plurality of tiles are electrically connected in series.

10. The display system of claim 9, wherein image or video data is being sent to a tile for display in a next frame while image or video data for a current frame is being displayed on the tile.

11. The display system of claim 6, wherein each illumination element is coupled to a first storage device and a second storage device.

12. The display system of claim 6, wherein:
each tile of the plurality of tiles further comprises a pixel array of pixel elements, each pixel element comprising one or more of the illumination elements of the plurality of illumination elements, wherein each illumination element of a pixel element of the pixel array is electrically coupled to the pixel logic circuitry;
the input/output logic circuitry comprises the memory component;
the memory component comprises a receiving pixel memory device and an active pixel memory device electrically coupled to the receiving pixel memory device;
the pixel logic circuitry comprises:
logic function circuitry coupled to the active pixel memory device;
a latch coupled to the logic function circuitry; and
a current drive device coupled to the latch, and wherein the current drive device drives operation of each pixel element of the pixel array; and
the tile controller comprises:
a deserializer that receives a data stream; and
a decoder, electrically coupled to the deserializer;
wherein:
the deserializer extracts image or video data from the data stream according to or when a tile's address is in the data stream, and controls writing of the image or video data to the receiving pixel memory device;
the decoder decodes the image or video data after it has been extracted from the data stream; and
the tile controller instructs a control logic block to write the image or video data that has been extracted and subsequently decoded to a data bus corresponding to or associated with a column that includes or contains at least one illuminating element or pixel element that has been identified as a destination for writing the image or video data that has been extracted and subsequently decoded.

13. The display system of claim 12, wherein the tile controller outputs a ROW/WRITE output or signal to a row of the illuminating elements or pixel elements that have been identified to receive the extracted and subsequently decoded image or video data.

14. The display system of claim 13, further comprising:
control logic circuitry of the tile controller that outputs a LOAD output voltage or signal that initiates transfer of data from the receiving pixel memory device to the active pixel memory device.

15. The display system of claim 14, further comprising:
a TVV, time-varying value, generator, wherein after the data has been transferred to the active pixel memory device, a display cycle begins, wherein during the display cycle, the TVV generator provides a changing value or voltage on a time-varying value, TVV, bus which pixel logic circuit or pixel logic device combines with the value or voltage in the active pixel memory device, and produces a time-varying voltage that is used to modulate a current driver circuit or device electrically coupled to a pixel element of the pixel array.

## Patentansprüche

1. Anzeigesystem, das Folgendes umfasst:
mehrere Kacheln, wobei eine Kachel Folgendes umfasst:
einen Beleuchtungschip, der mehrere Beleuchtungselemente umfasst, das mindestens eines von gekoppelt mit, ausgebildet in einem und integriert in ein Beleuchtungselementsubstrat ist; und
ein Backplane-Bauelement, das mit dem Beleuchtungschip gekoppelt ist, wobei das Backplane-Bauelement Folgendes umfasst:
ein Backplane-Substrat, das mehrere erste Streifenbereiche und mehrere zweite Streifenbereiche umfasst,
Pixellogikschaltung, die mindestens eines von angeordnet auf, eingebettet in, integriert in, ausgebildet auf, abgeschieden auf oder gekoppelt mit den mehreren ersten Streifenbereichen ist; und
Ein-/Ausgangslogikschaltung, die mindestens eines von angeordnet auf, eingebettet in, integriert in, ausgebildet auf, abgeschieden auf oder gekoppelt mit den mehreren zweiten Streifenbereichen ist,
und
Schaltung, die dazu konfiguriert ist, die mehreren Kacheln elektrisch zu koppeln,
und **dadurch gekennzeichnet, dass**
die ersten Streifenbereiche und die zweiten Streifenbereiche abwechselnd vorgesehen sind.

2. Anzeigesystem nach Anspruch 1, wobei der Beleuchtungschip derart mit einer Vorderseite des Backplane-Substrats gekoppelt ist, dass die mehreren ersten Streifenbereiche an den mehreren Beleuchtungselementen des Beleuchtungschips ausgerichtet sind.

3. Anzeigesystem nach Anspruch 2, wobei die mehreren Kacheln in einem Array auf einer Leiterplatte, PCB, angeordnet sind, wobei die PCB die Schaltung umfasst, die dazu konfiguriert ist, die mehreren Kacheln elektrisch zu koppeln.

4. Anzeigesystem nach Anspruch 3, wobei jede entsprechende Kachel durch mehrere Öffnungen in einer Rückseite des entsprechenden Backplane-Substrats mit der PCB gekoppelt ist, wobei die mehreren Öffnungen in der Rückseite an den mehreren zweiten Streifenbereichen der Backplane-Vorrichtung ausgerichtet sind.

5. Anzeigesystem nach Anspruch 3, wobei die PCB die mehreren Kacheln elektrisch in Reihe schaltet.

6. Anzeigesystem nach einem der Ansprüche 1 bis 5, wobei:
jede Kachel der mehreren Kacheln eine Kacheladresse und eine Kachelsteuerung hat; und
das Anzeigesystem ferner eine Master-Steuerung umfasst, die mit mindestens einer der Kacheln in der Mehrzahl oder dem Array von Kacheln gekoppelt ist, wobei die Master-Steuerung Daten zu der Kachel sendet, mit der sie gekoppelt ist, wobei die Daten einen Header mit einer Kacheladresse haben, und wobei die Kachelsteuerung Kacheldaten in den von der Master-Steuerung empfangenen Daten identifiziert, und wobei die Kacheldaten eine Teilmenge der von der Master-Steuerung gesendeten Daten sind, und wobei die mit der Kacheladresse assoziierte Kachel die Kacheldaten in einer Speicherkomponente in oder assoziiert mit der Kachel speichert.

7. Anzeigesystem nach Anspruch 6, wobei die Master-Steuerung Daten von einer ersten Vorrichtung eines ersten Formats empfängt, und wobei die Master-Steuerung die Daten in ein zweites Format umwandelt, das für die Kachel geeignet ist oder von der Kachel gelesen oder verarbeitet werden kann.

8. Anzeigesystem nach Anspruch 7, wobei die erste Vorrichtung eine Vorrichtung ist, die Bild-oder Videodaten erzeugt und/oder ausgibt.

9. Anzeigesystem nach Anspruch 6, wobei die Kacheln der mehreren Kachel elektrisch in Reihe geschaltet sind.

10. Anzeigesystem nach Anspruch 9, wobei Bild- oder Videodaten zu einer Kachel zur Anzeige in einem nächsten Frame gesendet werden, während Bild- oder Videodaten für einen aktuellen Frame auf der Kachel angezeigt werden.

11. Anzeigesystem nach Anspruch 6, wobei jedes Beleuchtungselement mit einer ersten Speichervorrichtung und einer zweiten Speichervorrichtung gekoppelt ist.

12. Anzeigesystem nach Anspruch 6, wobei:
jede Kachel der mehreren Kacheln ferner ein Pixelarray von Pixelelementen umfasst, wobei jedes Pixelelement eines oder mehrere der Beleuchtungselemente der mehreren Beleuchtungselemente umfasst, wobei jedes Beleuchtungselement eines Pixelelements des Pixelarrays elektrisch mit der Pixellogikschaltung gekoppelt ist;
die Ein-/Ausgangslogikschaltung die Speicherkomponente umfasst;
die Speicherkomponente eine Empfangspixel-Speichervorrichtung und eine Aktivpixel-Speichervorrichtung umfasst, die elektrisch mit der Empfangspixel-Speichervorrichtung gekoppelt ist;
die Pixellogikschaltung Folgendes umfasst:
Logikfunktionsschaltung, die mit der Aktivpixel-Speichervorrichtung gekoppelt ist;
einen Latch, der mit der Logikfunktionsschaltung gekoppelt ist; und
eine Stromtreibervorrichtung, die mit dem Latch gekoppelt ist, und wobei die Stromtreibervorrichtung den Betrieb jedes Pixelelementss des Pixelarrays steuert; und
die Kachelsteuerung Folgendes umfasst:
einen Deserialisierer, der einen Datenstrom empfängt; und
einen Decoder, der elektrisch mit dem Deserialisierer gekoppelt ist;
wobei:
der Deserialisierer Bild- oder Videodaten aus dem Datenstrom extrahiert, je nachdem ob oder wenn sich die Adresse einer Kachel im Datenstrom befindet, und das Schreiben der Bild- oder Videodaten in die Empfangspixel-Speichervorrichtung steuert;
der Decoder die Bild- oder Videodaten decodiert, nachdem sie aus dem Datenstrom extrahiert wurden; und
die Kachelsteuerung einen Steuerlogikblock anweist, die extrahierten und anschließend decodierten Bild- oder Videodaten in einen Datenbus zu schreiben, der einer Spalte entspricht oder damit assoziiert ist, die mindestens ein Beleuchtungselement oder Pixelelement enthält, die als Ziel für das Schreiben der extrahierten und anschließend decodierten Bild- oder Videodaten identifiziert wurden.

13. Anzeigesystem nach Anspruch 12, wobei die Kachelsteuerung ein(en) ROW/WRITE-Ausgang oder -Signal an eine Reihe der Beleuchtungselemente oder Pixelelemente ausgibt, die zum Empfangen der extrahierten und anschließend decodierten Bild- oder Videodaten identifiziert wurden.

14. Anzeigesystem nach Anspruch 13, das ferner Folgendes umfasst:
Steuerlogikschaltung der Kachelsteuerung, die ein(e) LOAD-Ausgangsspannung oder -signal ausgibt, die/das die Übertragung von Daten von der Empfangspixel-Speichervorrichtung zur Aktivpixel-Speichervorrichtung initiiert.

15. Anzeigesystem nach Anspruch 14, das ferner Folgendes umfasst:
einen TVV, Time-Varying-Value,-Generator, wobei nach der Übertragung der Daten zur Aktivpixel-Speichervorrichtung ein Anzeigezyklus beginnt, wobei während des Anzeigezyklus der TVV-Generator eine(n) sich ändernde(n) Wert oder Spannung auf einem TVV, Time-Varying-Value,-Bus bereitstellt, den die Pixellogikschaltung oder die Pixellogikvorrichtung mit dem Wert oder der Spannung in der Aktivpixel-Speichervorrichtung kombiniert, und eine zeitlich variierende Spannung erzeugt, die zum Modulieren einer Stromtreiberschaltung oder - vorrichtung verwendet wird, die elektrisch mit einem Pixelelement des Pixelarrays gekoppelt ist.

## Revendications

1. Système d'affichage, comprenant :
une pluralité de tuiles, dans lequel une tuile comprend :
un dé d'éclairement comprenant une pluralité d'éléments d'éclairement qui sont au moins l'un parmi couplés à, formés dans et intégrés dans un substrat d'éléments d'éclairement ; et
un dispositif de fond de panier couplé au dé d'éclairement, ledit dispositif de fond de panier comprenant :
un substrat de fond de panier comprenant une pluralité de premières zones de bandes et une pluralité de secondes zones de bandes ;
une circuiterie logique de pixels qui est au moins l'une parmi disposée sur, incorporée dans, intégrée dans, formée sur, déposée sur ou couplée à la pluralité de premières zones de bandes ; et
une circuiterie logique d'entrée/sortie qui est au moins l'une parmi disposée sur, incorporée dans, intégrée dans, formée sur, déposée sur ou couplée à la pluralité de secondes zones de bandes,
et
une circuiterie configurée pour coupler électriquement la pluralité de tuiles,
et **caractérisé en ce que**
les premières zones de bandes et les secondes zones de bandes sont disposées de manière alternée.

2. Système d'affichage selon la revendication 1, dans lequel le dé d'éclairement est couplé à une surface avant du substrat de fond de panier de manière que la pluralité de premières zones de bandes soit alignée avec la pluralité d'éléments d'éclairement du dé d'éclairement.

3. Système d'affichage selon la revendication 2, dans lequel la pluralité de tuiles est disposée en une matrice sur une carte de circuit imprimé, PCB, la PCB comprenant la circuiterie configurée pour coupler électriquement la pluralité de tuiles.

4. Système d'affichage selon la revendication 3, dans lequel chaque tuile respective est couplée à la PCB par l'intermédiaire d'une pluralité d'ouvertures dans une surface arrière du substrat de fond de panier respectif, la pluralité d'ouvertures dans la surface arrière étant alignée avec la pluralité de secondes zones de bandes du dispositif de fond de panier.

5. Système d'affichage selon la revendication 3, dans lequel la PCB couple électriquement la pluralité de tuiles en série.

6. Système d'affichage selon l'une quelconque des revendications 1 à 5, dans lequel :
chaque tuile de la pluralité de tuiles possède une adresse de tuile et un contrôleur de tuile ; et
le système d'affichage comprend en outre un contrôleur principal couplé à au moins l'une des tuiles de la pluralité ou de la matrice de tuiles, dans lequel le contrôleur principal envoie des données à la tuile à laquelle il est couplé, les données possédant un en-tête comportant une adresse de tuile, et dans lequel le contrôleur de tuile identifie des données de tuile dans les données reçues à partir du contrôleur principal, et dans lequel des données de tuile sont un sous-ensemble des données envoyées par le contrôleur principal, et dans lequel la tuile associée à l'adresse de tuile stocke les données de tuile au niveau d'un composant de mémoire dans, ou associé à, la tuile.

7. Système d'affichage selon la revendication 6, dans lequel le contrôleur principal reçoit des données à partir d'un premier dispositif d'un premier format, et dans lequel le contrôleur principal convertit les données dans un second format approprié pour, ou qui peut être lu ou traité par, la tuile.

8. Système d'affichage selon la revendication 7, dans lequel le premier dispositif est un dispositif qui génère et/ou fournit des données d'image ou vidéo.

9. Système d'affichage selon la revendication 6, dans lequel les tuiles de la pluralité de tuiles sont reliées électriquement en série.

10. Système d'affichage selon la revendication 9, dans lequel des données d'image ou vidéo sont envoyées à une tuile pour être affichées dans une trame suivante tandis que des données d'image ou vidéo pour une trame actuelle sont affichées sur la tuile.

11. Système d'affichage selon la revendication 6, dans lequel chaque élément d'éclairement est couplé à un premier dispositif de stockage et à un second dispositif de stockage.

12. Système d'affichage selon la revendication 6, dans lequel :
chaque tuile de la pluralité de tuiles comprend en outre une matrice de pixels d'éléments de pixels, chaque élément de pixel comprenant un ou plusieurs des éléments d'éclairement de la pluralité d'éléments d'éclairement, dans lequel chaque élément d'éclairement d'un élément de pixel de la matrice de pixels est couplé électriquement à la circuiterie logique de pixels ;
la circuiterie logique d'entrée/sortie comprend le composant de mémoire ;
le composant de mémoire comprend un dispositif de mémoire de pixel de réception et un dispositif de mémoire de pixel actif couplé électriquement au dispositif de mémoire de pixel de réception ;
la circuiterie logique de pixels comprend :
une circuiterie de fonction logique couplée au dispositif de mémoire de pixel actif ;
un verrou couplé à la circuiterie de fonction logique ; et
un dispositif de pilotage de courant couplé au verrou, et dans lequel le dispositif de pilotage de courant pilote le fonctionnement de chaque élément de pixel de la matrice de pixels ; et
le contrôleur de tuile comprend :
un désérialiseur qui reçoit un flux de données ; et
un décodeur, couplé électriquement au désérialiseur ;
dans lequel :
le désérialiseur extrait des données d'image ou vidéo du flux de données en fonction de l'adresse d'une tuile ou lorsque l'adresse d'une tuile se trouve dans le flux de données, et commande l'écriture des données d'image ou vidéo dans le dispositif de mémoire de pixel de réception ;
le décodeur décode les données d'image ou vidéo après qu'elles ont été extraites du flux de données ; et
le contrôleur de tuile ordonne à un bloc logique de commande d'écrire les données d'image ou vidéo qui ont été extraites puis décodées sur un bus de données correspondant à ou associé à une colonne qui comporte ou contient au moins un élément d'éclairement ou un élément de pixel qui a été identifié en tant que destination pour l'écriture des données d'image ou vidéo qui ont été extraites puis décodées.

13. Système d'affichage selon la revendication 12, dans lequel le contrôleur de tuile fournit une sortie ou un signal ROW/WRITE à une rangée des éléments d'éclairement ou des éléments de pixels qui ont été identifiés pour recevoir les données d'image ou vidéo extraites puis décodées.

14. Système d'affichage selon la revendication 13, comprenant en outre :
une circuiterie logique de commande du contrôleur de tuile qui fournit une tension ou un signal de sortie LOAD qui initie le transfert de données à partir du dispositif de mémoire de pixel de réception vers le dispositif de mémoire de pixel actif.

15. Système d'affichage selon la revendication 14, comprenant en outre :
un générateur de valeurs variables dans le temps, TVV, dans lequel, après que les données ont été transférées au dispositif de mémoire de pixel actif, un cycle d'affichage commence, dans lequel pendant le cycle d'affichage, le générateur TVV fournit une valeur ou une tension variable sur un bus de valeurs variables dans le temps, TVV, que le circuit logique de pixel ou le dispositif logique de pixel combine avec la valeur ou la tension dans le dispositif de mémoire de pixel actif, et produit une tension variable dans le temps qui est utilisée pour moduler un circuit ou un dispositif de pilotage de courant couplé électriquement à un élément de pixel de la matrice de pixels.
